Europäisches Patentamt

European Patent Office

Office européen des brevets

(11) Veröffentlichungsnummer : **0 379 604 B1**

(12) # EUROPÄISCHE PATENTSCHRIFT

(45) Veröffentlichungstag der Patentschrift :
**31.05.95 Patentblatt 95/22**

(51) Int. Cl.⁶ : **G03F 7/09, H01L 21/033, H01L 21/318, H01L 21/311**

(21) Anmeldenummer : **89101134.8**

(22) Anmeldetag : **23.01.89**

(54) **Verfahren zum Herstellen einer Siliziumnitridschicht, wie sie als Antireflexschicht in Photolithographieprozessen bei der Herstellung hochintegrierter Halbleiterschaltungen verwendet wird.**

(43) Veröffentlichungstag der Anmeldung :
**01.08.90 Patentblatt 90/31**

(45) Bekanntmachung des Hinweises auf die Patenterteilung :
**31.05.95 Patentblatt 95/22**

(84) Benannte Vertragsstaaten :
**AT DE FR GB IT NL**

(56) Entgegenhaltungen :
**EP-A- 0 098 582**
**DE-A- 3 234 066**
**DE-A- 3 428 565**
**DE-A- 3 435 750**
**GB-A- 2 170 649**
**THIN SOLID FILMS, Band 69, Nr. 2, Juni 1980, Seiten 149-155, LAUSANNE, CH; W. POSA-DOWSKI: "Properties of silicon nitride thin films obtained by reactive sputtering"**

(56) Entgegenhaltungen :
**JOURNAL OF THE ELECTROMECHANICAL SOCIETY, Band 130, Nr. 3, März 1983, Seiten 638-644, Manchester, New Hampshire, USA; D. BOUCHIER et al.: "Low Temperature Deposition of Silicon Nitride by Reactive Ion-Beam Sputtering"**
**JOURNAL OF VACUUM SCIENCE & TECHNOLOGY A, Band 5, Nr. 4, Part III, Juli-August 1987, Seiten 1793, 1794, Woodbury, NY, USA; M. KITABATAKE et al.: "Summary Abstract: Hydrogen-free SiN films prepared by ion-beam sputter deposition"**

(73) Patentinhaber : **SIEMENS AKTIENGESELLSCHAFT Wittelsbacherplatz 2 D-80333 München (DE)**

(72) Erfinder : **Joswig, Hellmut, Dr. Maxlrainstrasse 2 D-8000 München 90 (DE)**
Erfinder : **Kücher, Peter, Dr. Ulrich-v.-Hutten-Strasse 15 D-8000 München 83 (DE)**

EP 0 379 604 B1

**Beschreibung**

Die Erfindung betrifft ein Verfahren zum Herstellen einer als Antireflexschicht bei der Herstellung von metallischen Strukturen für hochintegrierte Halbleiterschaltungen auf photolithographischem Wege zu verwendende Siliziumnitridschicht.

In der Mikroelektronik werden Schaltungen mit hoher Packungsdichte eingesetzt. Dies führt zu kleinen Strukturbreiten auch bei der Metallisierung der hochintegrierten Schaltkreise. Die typischen Leiterbahnbreiten liegen zwischen 1,0 und 20 µm. In unteren Metallisierungsebenen werden zunehmend Verbindungen aus Polyciden, das sind Legierungen aus polykristallinem Silizium und einem Metallsilizid, bei der Verdrahtung höherer Metallisierungsebenen Aluminium-Legierungen, zum Beispiel Aluminium-Silizium, Aluminium-Silizium-Kupfer, Aluminium-Silizium-Titan, eingesetzt.

Die Strukturerzeugung erfolgt durch optische Lithographie mit Hilfe von Photolack, wobei zwischen Positiv- oder Negativ-Lack unterschieden wird. Beim Positiv-Lack wird der belichtete Teil bei der Entwicklung entfernt, beim Negativ-Lack wird der belichtete Teil anschließend gehärtet - zum Beispiel mit UV-Licht - und der Rest bei der Entwicklung entfernt. In beiden Fällen entsteht eine Ätzmaske für das anschließend Ätzen der Verdrahtung. Das Ätzen kann sowohl naßchemisch als auch durch reaktives Ionenätzen erfolgen.

Bei der optischen Lithographie mit Positiv-Lack wird mit Licht durch eine Maske in den Photolack belichtet. Die für die Verdrahtung eingesetzten Materialien weisen aber eine hohe Reflektivität auf. Damit wird vor allem bei Topologieschwankungen und bei eng benachbarten Leiterbahnen auch Photolack belichtet, der nicht belichtet werden sollte. Dies führt beim Ätzen der Strukturen zu einer schlechten Maßhaltigkeit der Strukturen (Ätzverluste, verstärkte Korrosion, Ausfransungen). Bei Negativ-Photolacken entsteht ein Problem bei der Aushärtung der Lacke. Es kann zur Ausbildung stehender Wellen durch Interferenz kommen. Die Folge davon ist eine Schwankung in der Linienbreite der Bahnen.

Es werden verschiedene Arten von Antireflexschichten (= ARC) eingesetzt; sie werden durch chemische oder physikalische Schichtherstellungsverfahren als Deckschichten auf den Metallisierungsschichten vor der Belackung aufgebracht. Die bekannten ARC-Schichten bestehen aus Titan-Wolfram-Legierungen, Vanadin, Titannitrid, polykristallinem Silizium, amorphem Silizium (a:Si) und spin-on-Schichten mit einem absorbierenden Photolack. Sowohl der Effekt stehender Wellen als auch Linienbreitenschwankungen durch unterschiedliche Belichtungsdosen können damit reduziert werden (siehe Bericht von Lin, Y. C., Purdes, A. J., Saller, S. A., Int. Electron Devices Meeting, Technical Digest, San Francisco, 13. bis 15. Dezember 1982, Seiten 399 bis 402, 1982, New York).

Ein Verfahren zum Herstellen einer als Antireflexschicht zu verwendenden Siliziumnitridschicht ist aus der europäischen Patentanmeldung 0 098 582 A2 zu entnehmen. Dabei wird die auch im nicht stöchiometrischen Verhältnis vorliegende Siliziumnitridschicht durch ein CVD-Verfahren (= chemical vapor deposition) hergestellt.

Die Intensität des transmittierten Lichtes durch die Antireflexschicht ergibt sich zu

$$I = I_o . e^{-\alpha d}$$

Die Intensität des transmittierten Lichts wird also sowohl durch den Absorptionskoeffizienten $\alpha$ als auch durch die Dicke d der Antireflexschicht bestimmt. Mit der nicht stöchiometrischen Siliziumnitridschicht kann ein hoher Absorptionskoeffizient erreicht werden. Die Herstellung der Schicht verlangt aber eine hohe Gleichmäßigkeit der Abscheidung bei Wafergrößen bis 200 mm Durchmesser. Die in der europäischen Patentanmeldung 0 098 582 angegebenen Herstellungsverfahren erlauben keine gute Reproduzierbarkeit und Gleichmäßigkeit im interessanten Schichtdickenbereich für Antireflexschichten (das ist im Bereich von 5 bis 200 nm) bei diesen Wafergrößen.

Ein Sputterverfahren zum Herstellen von N-Schichten ist im Journal of Vacuum Science and Technology A, 5 (1987) Juli-Aug., Nr. 4, Part III, Seiten 1793, 1794, M. Kitabatake und K. Wasa beschrieben. Die Abscheidung erfolgt dabei in einem Druckbereich, der um eine Grössenordnung niedriger ist als der Druckbereich gemäss vorliegender Erfindung. Für das Sputtergas wird ein Mischungsverhältnis N2/Ar 2-6 angegeben. Von Absorptionseigenschaften im Sinne einer Antireflexschicht ist nicht die Rede, sondern es wird lediglich eine Absorption bei einer bestimmten Wellenlänge im Infraroten erwähnt. Im übrigen stellt dieses Dokument ganz überwiegend auf die Erzeugung einer möglichst wasserstofffreien, annähernd stöchiometrischem Si3N4-Schicht ab.

Ein weiteres Sputterverfahren ist aus Thin solid films, Vol. 69 (1980), Juni, Nr. 2, Seiten 149-155, W. Posodowski bekannt. Auch dieses Dokument geht nicht auf Antireflexschichten ein und beschäftigt sich im wesentlichen mit dem Langzeitverhalten spezieller elektrischer Eigenschaften gesputterter Schichten. Der Druckbereich ist wiederum erheblich niedriger als der Druckbereich gemäss vorliegender Erfindung und primär wird ein Siliziumnitrid-Film mit guter Stöchiometrie angestrebt.

Aufgabe der Erfindung ist es nun, ein Verfahren zum Herstellen einer als Antireflexschicht mit extrem niedriger Reflektivität geeigneten Siliziumnitridschicht anzugeben, welches nicht nur eine hohe Gleichmäßigkeit bei der Herstellung erreicht, sondern auch Temperaturbelastungen vermeidet.

Diese Aufgabe wird bei einem Verfahren der eingangs genannten Art dadurch gelöst, daß die Siliziumnitridschicht als nicht-stöchiometrische Schicht einer Verbindung aus amorphem Silizium und Stickstoff a-Si:N mit einem Stickstoffanteil von 0.3 bis 0.8 durch reaktives Aufstäuben bei einer Substrattemperatur kleiner 100°C in einem Argon-Stickstoff-Gemisch abgeschieden wird wobei die Leistung beim Aufstäuben, dem sogenannten Sputtern, im Bereich von 0,2 bis 3 KW und der Druck des Argon-Stickstoff-Gemisches im Bereich von 0,133-1,33 Pa (1-10 mTorr) bei einem Argon-Stickstoff-Flussverhältnis von 30:1 bis 3:1 eingestellt wird. Der Stickstoffanteil kann in diesem Bereich je nach Belichtungswellenlänge eingestellt werden, um eine optimale Reflektivitätsminderung zu erreichen.

In einer Weiterbildung des Erfindungsgedankens ist vorgesehen, die a-Si:N-Schicht zyklisch lagenweise abzuscheiden, wobei in einem Zyklus auch mehrere Siliziumtargets verwendet werden können.

Weitere Ausgestaltungen der Erfindung ergeben sich aus den Unteransprüchen.

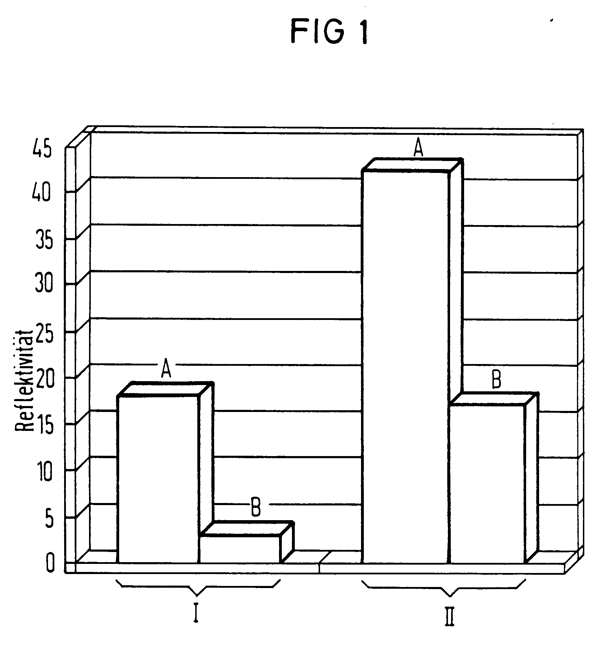

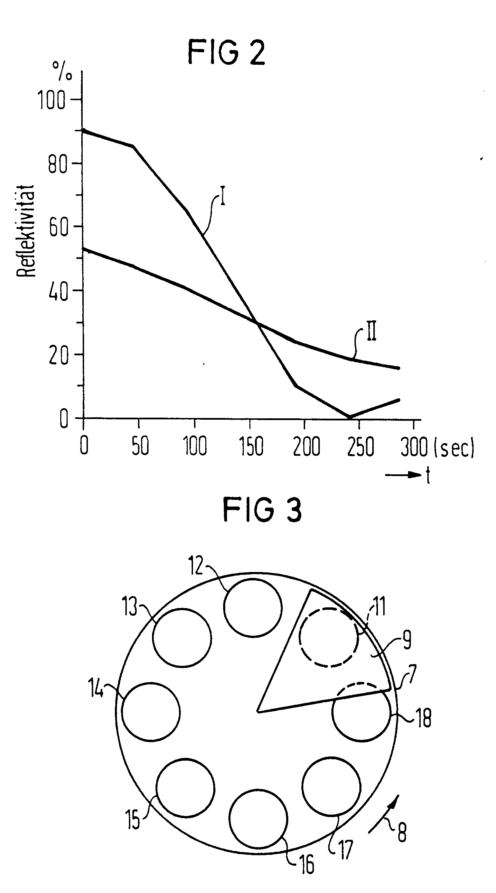

Mit dem erfindungsgemäßen Schichtsystem kann die Reflektivität erheblich stärker als mit den bisher verwendeten ARC-Schichten reduziert werden. Bei dem Aufstäubverfahren ist zudem die Temperaturbelastung geringer. Temperaturen über 200°C führen zum Beispiel bei Aluminium-Legierungen zur Ausbildung von sogenannten Hillocks, die zu Kurzschlüssen zwischen zwei Metallisierungsebenen führen können. Mit einem Aufstäubverfahren hergestellte Schichten zeichnen sich zudem durch eine kostengünstigere Herstellung und bessere Reproduzierbarkeit auch bei extrem dünnen Schichten aus. Durch reaktives Aufstäuben in einem Argon/Stickstoff-Gemisch können Schichten mit extrem niedriger Reflektivität sowohl auf Silizid als auch auf Aluminiumlegierungsschichten hergestellt werden, wie auf der Figur 1 zu ersehen ist. Die Reflektivität liegt im Vergleich zu bisher bekannten ARC-Schichten deutlich niedriger (siehe Figur 2).

Weitere Einzelheiten der Erfindung werden nachfolgend anhand von Ausführungsbeispielen und der Figuren 1 bis 3 noch näher beschrieben. Dabei zeigt

die Figur 1       im Diagramm einen Vergleich in bezug auf die Reflektivität des erfindungsgemäßen Schichtsystems mit einer bereits bekannten Antireflexschicht aus amorphem Silizium,

die Figur 2       die Abhängigkeit der Reflektivität von der Sputterzeit und

die Figur 3       in Draufsicht die für die Herstellung der erfindungsgemäßen Schicht vorgesehene Palette mit Sputtertarget.

Figur 1: Wie aus den Säulendiagrammen ersichtlich ist, sinkt die Reflektivität sowohl auf Aluminium- (I) als auch auf Molybdänsilizid (II)-Oberflächen erheblich; bei Aluminium von 15 bis 20 Prozent (bei Verwendung von amorphem Silizium) auf ca. 3 Prozent (bei Verwendung von gesputterten amorphem Silizium mit Stickstoffbeimischung. Die Reflektivität sinkt bei Molybdänsilizid von 40 bis 45 Prozent auf 15 bis 20 Prozent bei Anwendung des erfindungsgemäßen Verfahrens. Die Säulen A beziehen sich auf a-Si-ARC-Schichten, die Säulen B auf a-Si:NSchichten.

Figur 2: Mit der Abszisse ist die Sputterzeit t, mit der Ordinate die Reflektivität in Prozent bezeichnet. Die Kurve I gilt für die Anwendung des erfindungsgemäßen Verfahrens auf Aluminiumschichten, die Kurve II für Molybdänsilizid.

Für beide Kurvendiagramme wurden folgende Prozeßparameter eingestellt:

Sputterleistung:       0,2 bis 1 kW
Druck (Argon/Stickstoff-Gemisch):   0,133-1,33 Pa (1 bis 10 mTorr)
Flußverhältnis Argon/Stickstoff:     typisch 150/10
Temperatur:       Raumtemperatur

Figur 3: Die Beschichtung wird in einem sogenannten Batch-System (DC-Einkammer-Sputteranlage) durchgeführt. Mit dem Bezugszeichen 7 ist die drehbar (siehe Pfeil 8) ausgebildete Palette bezeichnet, auf der acht Scheibenpositionen (11 bis 18) vorhanden sind, die bei jeder Fahrt mit den zu beschichtenden Substraten zu bestücken sind. Der Targethalter mit dem Siliziumtarget ist mit dem Bezugszeichen 9 bezeichnet. Wie aus der Figur ersichtlich ist, befindet sich jeweils mindestens eines (11, 15) der acht Substrate (11 bis 18) unter dem Target 9. Der Sputterprozeß wird beispielsweise so eingestellt, daß bei einer Gesamtschichtdicke von 30 nm 15 Umdrehungen der Palette 7 durchgeführt werden. Die Dauer des Aufstäubens beträgt für jeweils 8 Substrate 240 Sekunden.

Nach der Strukturierung der Leiterbahnen wird im allgemeinen die Antireflexschicht naßchemisch oder durch reaktives Ionenätzen entfernt. Dies gilt besonders für Silizidschichten, die zur Silizidbildung noch einem Hochtemperaturschritt (T ungefähr 800°C) unterzogen werden.

Ein Vorteil bei der Verwendung von erfindungsgemäßen a-Si:N-Schichten gegenüber metallischen Antireflexschichten (zum Beispiel aus Titanwolfram, Titannitrid, Vanadium usw.) auf Silizidschichten (zum Beispiel Tantalsilizid, Molybdänsilizid usw.) ist, daß bei etwaigen Resten von a-Si:N auf dem Silizid nach dem Ätzen keine Probleme bei der Silizidbildung auftreten.

## Patentansprüche

1. Verfahren zum Herstellen einer als Antireflexschicht bei der Herstellung von metallischen Strukturen für hochintegrierte Halbleiterschaltungen auf photolithographischem Wege zu verwendenden Siliziumnitridschicht, bei dem die Siliziumnitridschicht als nichtstöchiometrische Schicht einer Verbindung aus amorphem Silizium und Stickstoff a-Si:N mit einem Stickstoffanteil von 0.3 bis 0.8 durch reaktives Aufstäuben bei einer Substrattemperatur kleiner 100°C in einem Argon-Stickstoff-Gemisch abgeschieden wird, wobei die Leistung beim Aufstäuben (Sputtern) im Bereich von 0,2 bis 3 kW und der Druck des Argon-Stickstoff-Gemisches im Bereich von 0,133-1,33 Pa (1 bis 10 mTorr) bei einem Argon-Stickstoff-Flußverhältnis von 30:1 bis 3:1 eingestellt wird.

2. Verfahren nach Anspruch 1, **dadurch gekennzeichnet**, daß die nicht-stöchiometrische a-Si:N-Schicht zyklisch lagenweise (8) abgeschieden wird.

3. Verfahren nach Anspruch 2, **dadurch gekennzeichnet**, daß in einem Zyklus (8) mehrere Silizium-Targets (9) verwendet werden.

4. Verfahren nach mindestens einem der Ansprüche 1 bis 3, **dadurch gekennzeichnet**, daß die Schichtdicke der einzelnen Lagen im Bereich von 2 nm eingestellt wird und mindestens 15 Lagen abgeschieden werden.

5. Verfahren nach mindestens einem der Ansprüche 1 bis 4, **dadurch gekennzeichnet**, daß eine Einkammer-Sputteranlage verwendet wird, bei der die für die Beschichtung vorgesehenen Substrate (11 bis 18) auf einer in der Horizontalen drehbaren (8) Palette (7) ortsfest angeordnet sind, die Palette (7) während der Beschichtung in Umdrehungen (8) versetzt wird und die Drehgeschwindigkeit so eingestellt wird, daß eine Umdrehung (8) einem Zyklus entspricht.

## Claims

1. Method for producing a silicon nitride layer to be used as an antireflection coating in the production of metallic structures for large-scale integrated semiconductor circuits by photolithographic means, wherein the silicon nitride layer is deposited as a non-stoichiometric coating of a compound comprising amorphous silicon and nitrogen a-Si:N having a nitrogen content of 0.3 to 0.8 by reactive sputtering at a substrate temperature of less than 100°C in an argon-nitrogen mixture, the power during the sputtering being set in the range from 0.2 to 3 kW and the pressure of the argon-nitrogen mixture being set in the range from 0.133 - 1.33 Pa (1 to 10 mTorr) with an argon-nitrogen flux ratio of 30:1 to 3:1.

2. Method according to Claim 1, characterized in that the non-stoichiometric a-Si:N layer is deposited cyclically in layers (8).

3. Method according to Claim 2, characterized in that a plurality of silicon targets (9) is used in one cycle (8).

4. Method according to at least one of Claims 1 to 3, characterized in that the layer thickness of the individual layers is set in the region of 2 nm and at least 15 layers are deposited.

5. Method according to at least one of Claims 1 to 4, characterized in that a single-chamber sputtering system is used, in which the substrates (11 to 18) intended to be coated are arranged fixed on a pallet (7) which can be rotated (8) in the horizontal plane, the pallet (7) is caused to rotate (8) during the coating and the rotational speed is set so that one revolution (8) corresponds to one cycle.

## Revendications

1. Procédé de fabrication d'une couche de nitrure de silicium à utiliser comme couche anti-réfléchissante lors de la fabrication de structures métalliques pour des circuits à semi-conducteurs à haute densité d'intégration par voie photolithographique, qui consiste à déposer la couche de nitrure de silicium sous la forme d'une couche non stoechiométrique d'un composé constitué de silicium amorphe et d'azote (a-Si:N) ayant une proportion d'azote de 0,3 à 0,8 par pulvérisation cathodique réactive à une température du substrat inférieure à 100°C dans un mélange d'argon et d'azote, la puissance lors de la pulvérisation cathodique (sputter) étant réglée entre 0,2 et 3 kW et la pression du mélange d'argon et d'azote entre 0,133 et 1,33 Pa (1 à 10 mTorr) pour un rapport de débit de l'argon à l'azote de 30:1 à 3:1.

2. Procédé suivant la revendication 1, caractérisé en ce qu'il consiste à déposer cycliquement couche par couche (8) la couche non stoechiométrique de a-Si:N.

3. Procédé suivant la revendication 2, caractérisé en ce qu'il consiste à utiliser dans un cycle (8) plusieurs cibles (9) en silicium.

4. Procédé suivant l'une au moins des revendications 1 à 3, caractérisé en ce qu'il consiste à régler l'épaisseur de chacune des couches à 2 nm environ et à déposer au moins 15 couches.

5. Procédé suivant l'une au moins des revendications 1 à 4, caractérisé en qu'il consiste à utiliser une installation de pulvérisation cathodique à une seule chambre, dans laquelle les substrats (11 à 18) prévus pour le revêtement sont montés à poste fixe sur une palette (7) pouvant tourner (8) dans un plan horizontal, la palette (7) pouvant être mise en rotation (8) pendant le revêtement et la vitesse de rotation étant réglée de manière qu'une rotation (8) corresponde à un cycle.

# FIG 1

# FIG 2

# FIG 3